# EUROPEAN PATENT APPLICATION

(11) **EP 4 641 298 A1**
(43) Date of publication of application: **29.10.2025**
(21) Application number: 25164063.7
(22) Date of filing: 17.03.2025
(51) Int. Cl.: G03F 7/075, G03F 7/09, G03F 7/11, H01L 21/027

(54) **SUBSTRATE PROCESSING METHOD AND SUBSTRATE PROCESSING APPARATUS**

(30) Priority: 21.03.2024 JP 2024044941
(71) Applicant: SCREEN Holdings Co., Ltd., Kyoto-shi, Kyoto 602-8585 (JP)
(72) Inventor: HARUMOTO, Masahiko, Kyoto, 602-8585 (JP)
(74) Representative: Kilian Kilian & Partner mbB

(57) **Abstract**

A substrate processing method includes a first layer (101) generation step of applying a first coating liquid containing an organic material and a first photo-crosslinking agent onto a substrate to form a first layer (101), a second layer (102) generation step of applying a second coating liquid containing a silicon material and a second photo-crosslinking agent onto the first layer (101) to generate a second layer (102), and a light irradiation step of irradiating a stacked body formed of the first layer (101) and the second layer (102) with light, curing the first layer (101) through a crosslinking reaction to form the organic layer, and curing the second layer (102) through a crosslinking reaction to form the silicon layer (106).

## Description

### Background of the invention

The present invention relates to a substrate processing method and a substrate processing apparatus for forming a photoresist layer on a substrate.

### Description of the Related Art

In recent years, a multilayer film has been used as a mask layer to improve etching resistance when a processing target film on a silicon substrate is etched. For example, JP 2021-86993 A describes a substrate processing method including irradiating an underlayer film (organic layer) containing carbon or the like as a main component with ultraviolet light when the underlayer film is formed on a film to be processed of a substrate. This method can improve the adhesion between the underlayer film and the resist film formed on the underlayer film and further reduce the pattern width that can be generated in the resist film.

JP 2002-198295 A describes a substrate processing method for forming an underlayer resist film (organic layer) containing carbon as a main component on a processing target layer on a substrate surface. The underlayer resist film can be formed by applying a solution obtained by dissolving a novolak resin or the like in a solvent using a spin coating method or the like and baking the solution on a hot plate, an oven, or the like. A coating material formed by dissolving a silicon compound in a predetermined organic solvent is applied to the surface of the underlayer resist film to form an interlayer film (silicon layer). To form the interlayer film, the coating material on the substrate surface is heated to vaporize the organic solvent. The resist film is formed on the surface of the interlayer film.

In JP 4993119 B, a polymerizable compound having an ethylenically unsaturated bond that cures with a photo-crosslinking agent is used as the underlayer film. That is, the substrate processing method of JP 4993119 B includes a step of applying a lower film forming composition onto a semiconductor substrate to form a coating film, and irradiating the coating film with light to form a lower film.

### <List of Documents>

JP 2021-86993 A
JP 2002-198295 A
JP 4993119 B

However, in the conventional substrate processing method, it cannot be said that the film forming method is optimized in the substrate processing of forming a spin on carbon (SOC) layer (organic layer generated by spin coating) and a spin on glass (SOG) layer (silicon layer generated by spin coating) under a photoresist layer. To form the SOC layer, the SOG layer, and the photoresist layer on the substrate surface in this order, it is necessary to go through many steps. That is, in the conventional configuration, each layer is formed by performing a repetitive operation such as generating an SOC layer on a substrate surface and then generating an SOG layer. Since the formation of each layer includes a firing process and an ultraviolet light irradiation process, as the number of layers to be formed on the substrate surface increases, the steps of substrate processing increases accordingly. It cannot be said that such a substrate processing method is not optimal from the viewpoint of power saving and downsizing of the apparatus.

The present invention has been made in view of such circumstances, and an object thereof is to provide a substrate processing method and a substrate processing apparatus capable of easily forming a plurality of layers.

### Summary of the invention

To solve the above problem, the present invention has the following configurations.

That is, the present invention is a substrate processing method for generating a stacked structure including an organic layer, a silicon layer, and a photoresist layer on a substrate, the substrate processing method including:
a first layer generation step of applying a first coating liquid containing an organic material and a first photo-crosslinking agent onto a substrate to form a first layer;
a second layer generation step of applying a second coating liquid containing a silicon material and a second photo-crosslinking agent onto the first layer to generate a second layer;
a light irradiation step of irradiating a stacked body formed of the first layer and the second layer with light, curing the first layer through a crosslinking reaction to form the organic layer, and curing the second layer through a crosslinking reaction to form the silicon layer; and
a photoresist layer generation step of generating a photoresist layer on the stacked body that has been cured.

### [Operation and Effect]

According to the substrate processing method described above, the method includes the first layer generation step of applying a first coating liquid containing an organic material and a first photo-crosslinking agent onto a substrate to form a first layer, the second layer generation step of applying a second coating liquid containing a silicon material and a second photo-crosslinking agent onto the first layer to generate a second layer, and the light irradiation step of irradiating a stacked body formed of the first layer and the second layer with light, curing the first layer through a crosslinking reaction to form the organic layer, and curing the second layer through a crosslinking reaction to form the silicon layer. That is, in the substrate processing method of the present invention, the second layer is formed on the first layer before the first layer is cured through a crosslinking reaction, and the first layer and the second layer are cured at once by light irradiation, whereby each of the organic layer and the silicon layer is generated According to the present invention, since the first layer and the second layer are cured together, the formation of a plurality of layers is simplified as compared with the method of forming the second layer after the organic layer is generated. The present invention can provide an optimal substrate processing method from the viewpoint of power saving and downsizing of the apparatus.

In the substrate processing method described above,
the first layer in the first layer generation step preferably includes a lower layer that becomes the organic layer in the light irradiation step and a higher layer that dissolves with the second coating liquid and disappears.

### [Operation and Effect]

According to the above configuration, the first layer in the first layer generation step includes the lower layer that becomes the organic layer in the light irradiation step and the higher layer that dissolves with the second coating liquid and disappears. This configuration can realize the configuration of the present invention only by forming the first layer to be thick.

In the substrate processing method described above,
a solvent of the second coating liquid in the second layer generation step is preferably less likely to dissolve the organic material than a solvent of the first coating liquid in the first layer generation step.

[Operation and Effect] According to the above configuration, the solvent of the second coating liquid in the second layer generation step is less likely to dissolve the organic material than the solvent of the first coating liquid in the first layer generation step. With this configuration, it becomes difficult for the second coating liquid to dissolve the first layer when the second coating liquid is applied to the first layer. Thus, a stacked structure of the first layer and the second layer can be generated without estimating the thickness of the layer to dissolve in the second coating liquid and forming the first layer thick.

In the substrate processing method described above,
the second coating liquid in the second layer generation step preferably contains an additive that promotes dissolution of the silicon material into the solvent.

[Operation and Effect] According to the above configuration, the second coating liquid in the second layer generation step contains an additive that promotes dissolution of the silicon material in the solvent. This configuration makes it easy to generate a stacked structure of the first layer and the second layer.

In the substrate processing method described above,
light for irradiation in the light irradiation step is preferably ultraviolet light having a wavelength of any of 172 nm to 385 nm.

[Operation and Effect] According to the above configuration, the light for irradiation in the light irradiation step has a wavelength of any of 172 nm to 385 nm. When the light for irradiation in the light irradiation step is ultraviolet light, the first layer and the second layer can reliably become the organic layer and the silicon layer.

In the substrate processing method described above,
the silicon layer preferably causes the light for irradiation to reach the first layer in the light irradiation step.

[Operation and Effect] According to the above configuration, the silicon layer causes the light for irradiation to reach the first layer in the light irradiation step. This configuration can prevent a situation in which the light for irradiation in the light irradiation step is absorbed by the silicon layer and does not reach the first layer, and the first layer can reliably become the organic layer.

The substrate processing method described above preferably includes:
a first firing step of removing a solvent contained in the first layer after the first layer generation step and before the second layer generation step; and
a second firing step of removing a solvent contained in the second layer after the second layer generation step and before the light irradiation step.

[Operation and Effect] According to the above configuration, the first firing step of removing the solvent contained in the first layer is included after the first layer generation step and before the second layer generation step. Such a configuration can reliably dry the first layer and thus can easily generate the organic layer. In addition, according to the above configuration, the second firing step of removing the solvent contained in the second layer is included after the second layer generation step and before the light irradiation generation step. Such a configuration can reliably dry the second layer and thus can easily generate the silicon layer.

In the substrate processing method described above, it is preferable that,
in the first firing step, the substrate is fired at any temperature from 100°C to 150°C, and
in the second firing step, the substrate is fired at any temperature from 100°C to 150°C.

[Operation and Effect] According to the above configuration, in the first firing step, the substrate is fired at any temperature from 100°C to 150°C. When the first firing step is low-temperature firing, a substrate processing method in which power is saved can be provided. In addition, according to the above configuration, in the second firing step, the substrate is fired at any temperature from 100°C to 150°C. When the second firing step is low-temperature firing, a substrate processing method in which power is saved can be provided.

The present specification also discloses an invention related to a substrate processing apparatus as described below.

That is, the present specification discloses a substrate processing apparatus that generates a stacked structure including an organic layer, a silicon layer, and a photoresist layer on a substrate, the substrate processing apparatus including:
a first chamber that supplies a first liquid containing at least an organic material and a first photo-crosslinking agent onto a substrate to generate a first layer;
a second chamber that supplies a second liquid containing at least a silicon material and a second photo-crosslinking agent onto the first layer to generate a second layer;
a light irradiation chamber that irradiates a stacked body formed of the first layer and the second layer with light to cure the first layer through a crosslinking reaction and generate an organic layer and to cure the second layer through a crosslinking reaction and generate a silicon layer; and
a third chamber that generates a photoresist layer on the silicon layer.

[Operation and Effect] The substrate processing apparatus includes a first chamber that supplies a first liquid containing at least an organic material and a first photo-crosslinking agent onto a substrate to generate a first layer, a second chamber that supplies a second liquid containing at least a silicon material and a second photo-crosslinking agent onto the first layer to generate a second layer, a light irradiation chamber that irradiates a stacked body formed of the first layer and the second layer with light to cure the first layer through a crosslinking reaction and generate an organic layer and to cure the second layer through a crosslinking reaction and generate a silicon layer, and a third chamber that generates a photoresist layer on the silicon layer. According to the present invention, since the first layer and the second layer are cured together, the formation of a plurality of layers is simplified as compared with the method of forming the second layer after the organic layer is generated. The present invention can provide an optimal substrate processing apparatus from the viewpoint of power saving and downsizing of the apparatus.

The present invention can provide a substrate processing method and a substrate processing apparatus capable of easily forming a plurality of layers.

### Brief description of the drawings

FIG. 1 is a plan view for describing an overall configuration of a substrate processing apparatus according to an embodiment;
FIG. 2 is a sectional view for describing a configuration of a light irradiation chamber according to the embodiment;
FIG. 3 is a sectional view for describing a configuration of the light irradiation chamber according to the embodiment;
FIG. 4 is a flowchart for describing a process for forming an underlayer according to the embodiment;
FIG. 5 is a sectional view for describing a process for forming the underlayer according to the embodiment;
FIG. 6 is a sectional view for describing a process for forming the underlayer according to the embodiment;
FIG. 7 is a sectional view for describing a process for forming the underlayer according to the embodiment;
FIG. 8 is a sectional view for describing a process for forming the underlayer according to the embodiment;
FIG. 9 is a sectional view for describing a process for forming a photoresist layer according to the embodiment;
FIG. 10 is a graph showing an appropriate ultraviolet light irradiation amount according to the embodiment; and
FIG. 11 is a flowchart for describing substrate processing according to the embodiment.

### Description of the preferred embodiments

Hereinafter, an embodiment of the present invention will be described with reference to the drawings. A photolithography apparatus according to the embodiment includes a stepper that performs exposure processing when a device is generated on a front surface of a substrate having the front surface and a back surface, and a substrate processing apparatus that performs necessary substrate processing before and after the exposure processing. A substrate processing apparatus of the present invention relates to a substrate processing method for generating a stacked structure including an organic layer, a silicon layer, and a photoresist layer on a substrate.

### Embodiment

### 1. Overall Configuration

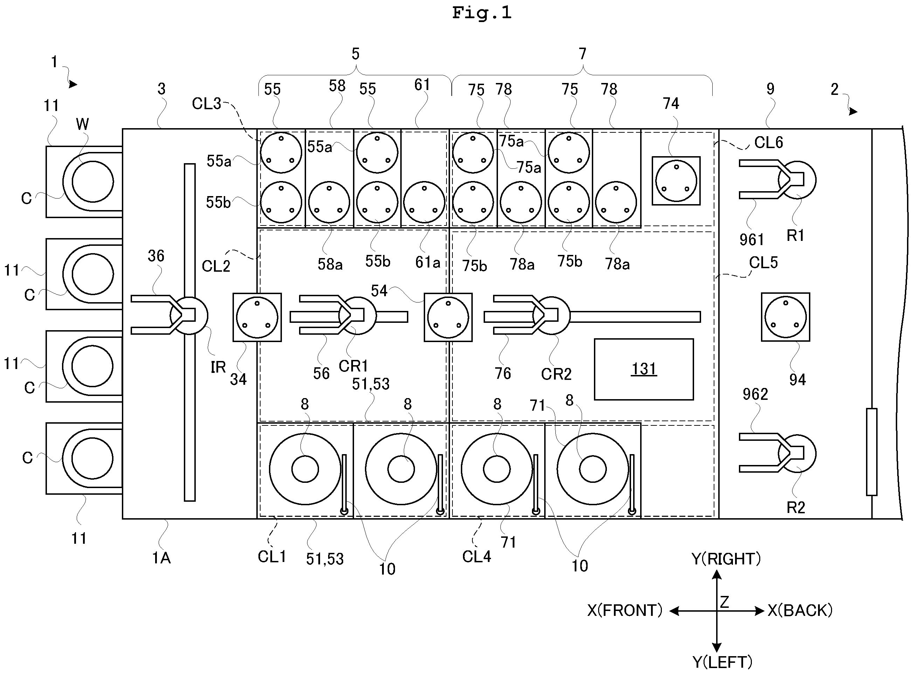

FIG. 1 is a plan view illustrating an overall configuration of a photolithography apparatus of the present embodiment. The photolithography apparatus of the present embodiment has a structure in which a substrate processing apparatus 1 and a stepper 2 are connected. The substrate processing apparatus 1 includes an indexer block 3, a coater block 5, a developer block 7, and an interface block 9. The indexer block 3, the coater block 5, the developer block 7, and the interface block 9 are arrayed in this order to form the substrate processing apparatus 1. The substrate processing apparatus 1 includes a housing 1A that stores each block. The housing 1A has a substantially rectangular shape in plan view. A load port 11 is provided to protrude from a wall surface on one end side of the housing 1A.

In this specification, for convenience, the directions in which the indexer block 3, the coater block 5, the developer block 7, and the interface block 9 in the substrate processing apparatus 1 are arrayed are referred to as front-back directions (X directions). The X directions extend horizontally. The direction from the coater block 5 toward the indexer block 3 in the substrate processing apparatus 1 is referred to as a front direction. The direction opposite to the front direction is referred to as a back direction. The horizontal directions orthogonal to the X direction are referred to as left-right directions (Y directions). The Y directions are also the directions in which the plurality of load ports 11 are arrayed. One of the Y directions is referred to as a right direction for convenience, and the direction opposite to the right direction is referred to as a left direction. Height directions (Z directions) are orthogonal to both the X directions and the Y directions and coincides with vertical directions. In each drawing, front, back, right, left, top, and bottom are illustrated as appropriate for reference.

### 2. Indexer Block

As illustrated in FIG. 1, the indexer block 3 includes a load port 11 that is an entrance of a carrier C when the carrier C storing a plurality of substrates W in a horizontal orientation at predetermined intervals in the Z directions is input into the block. The carrier C can be placed on the load port 11.

A plurality of (for example, 25) substrates W are stacked and stored in one carrier C. The carrier C storing unprocessed substrates W to be loaded into the substrate processing apparatus 1 is first placed on the load port 11.

In the indexer block 3, an indexer robot IR capable of conveying the substrates W in a horizontal orientation one by one is disposed. The indexer robot IR can access any of a path 34 provided at the boundary between the indexer block 3 and the coater block 5 illustrated in FIG. 1 and four load ports 11, and transfers the substrates W between the path 34 and the carrier C installed in the load port 11. A hand 36 achieves the transfer of the substrates W performed by the indexer robot IR.

### 3. Coater Block

The coater block 5 is configured to mainly form a photoresist layer on the substrate W before exposure processing. The coater block 5 includes a second line CL2 located at the back of the path 34, a first line CL1 provided on the left side of the second line CL2, and a third line CL3 located on the right side of the second line CL2. Thus, the second line CL2 is located at a position sandwiched between the first line CL1 and the third line CL3 from the left and right.

In the first line CL1, chemical liquid processing chambers having a spin chuck 8 that rotatably supports the substrate W and a nozzle 10 that discharges a chemical liquid are arrayed in the X directions. Thus, the chemical liquid processing chamber is configured to apply the chemical liquid to the surface of the substrate W. The chemical liquid processing chamber includes an underlayer film formation chamber 51 for forming a spin on carbon (SOC) layer (organic layer) and a spin on glass (SOG) layer (silicon layer), and a resist chamber 53 for forming a photoresist layer. The SOC layer corresponds to an organic layer of the present invention, and the SOG layer corresponds to a silicon layer of the present invention. In the first line CL1 of FIG. 1, a state in which two resist chambers 53 or two underlayer film formation chambers 51 are arrayed in the front-back directions is described. In the first line CL1, the underlayer film formation chamber 51 and the resist chamber 53 are stacked. The up-down relationship between the underlayer film formation chamber 51 and the resist chamber 53 can be appropriately changed. In the first line CL1, three or more chemical liquid processing chambers may be provided.

The underlayer film formation chamber 51 corresponds to a first chamber and a second chamber of the present invention. Via the nozzle 10, the chemical liquid related to film formation can be spin-coated on the substrate W, or spin drying for drying the applied chemical liquid can be performed. The underlayer film formation chamber 51 can selectively spin-coat the substrate W with a polymer aromatic compound dissolved in propylene glycol monomethylether acetate (PGMEA) or a silicon compound dissolved in PGMEA as the chemical liquid. The polymer aromatic compound corresponds to an organic material of the present invention, and the silicon compound corresponds to a silicon material of the present invention. The solvent constituting the chemical liquid is not limited to PGMEA, and may be, for example, propylene glycol monomethylether (PGME). The chemical liquid in which the polymer aromatic compound is dissolved is referred to as a first coating liquid. The first coating liquid is a chemical liquid for forming the SOC film. The chemical liquid in which the silicon compound is dissolved is referred to as a second coating liquid. The second coating liquid is a chemical liquid for forming the SOG film. In addition, the first coating liquid and the second coating liquid contain a photo-crosslinking agent for crosslinking and curing the polymer compounds. When irradiated with ultraviolet rays, the photo-crosslinking agent polymerizes different polymers so as to crosslink the polymers to form a network structure of the polymers. The photo-crosslinking agent is, for example, a photoradical polymerization initiator. The photo-crosslinking agent added to the first coating liquid is a first photo-crosslinking agent, and the photo-crosslinking agent added to the second coating liquid is a second photo-crosslinking agent. The underlayer film formation chamber 51 can also perform spin cleaning on the substrate W using a rinse liquid. The rinse liquid is, for example, pure water.

The resist chamber 53 can perform edge exposure related to removal of the photoresist layer at the peripheral portion of the substrate W in addition to formation of the photoresist layer. The edge exposure is not necessarily performed in the resist chamber 53, but may be realized by an edge exposure unit provided separately from the resist chamber 53. The edge exposure unit is provided in a third line CL3 to be described later or a sixth line CL6 in the developer block 7 to be described later.

The second line CL2 is a passage through which a first center robot CR1 that conveys the substrate W in a horizontal orientation moves back and forth. In addition to the above-described path 34, the first center robot CR1 can access an underlayer film formation chamber 51 included in the first line CL1, the resist chamber 53, a heat processing chamber 55 and a cooling unit 58, which will be described later, provided in the third line CL3, and a path 54 provided at the boundary between the coater block 5 and the developer block 7 illustrated in FIG. 1.

The first center robot CR1 is movable forward and backward in the X directions and movable up and down in the Z directions so as to be able to convey the substrate W to each accessible position. The first center robot CR1 can direct the hand 56 holding the substrate W to any of the front, back, left, and right.

In the third line CL3, a heat processing chamber 55 that heats the substrate W, a cooling unit 58 that cools the substrate W, and a light irradiation chamber 61 that irradiates the substrate W with ultraviolet light are arrayed in the X directions. The ultraviolet light corresponds to light of the present invention. In the heat processing chamber 55, a circular hot plate 55a that heats the substrate W and a circular post-heating processing plate 55b that performs post-heating processing for lowering the temperature of the substrate W having a high temperature are arrayed in the Y directions. The cooling unit 58 is provided with a circular cooling processing plate 58a that cools the substrate W having room temperature. In the third line CL3, the heat processing chamber 55, the cooling unit 58, or the light irradiation chamber 61 are not only arrayed in the X directions but also stacked in the Z directions to constitute a stacked body of chambers. The number of layers included in the stacked body can be appropriately changed.

### 4. Light Irradiation Chamber

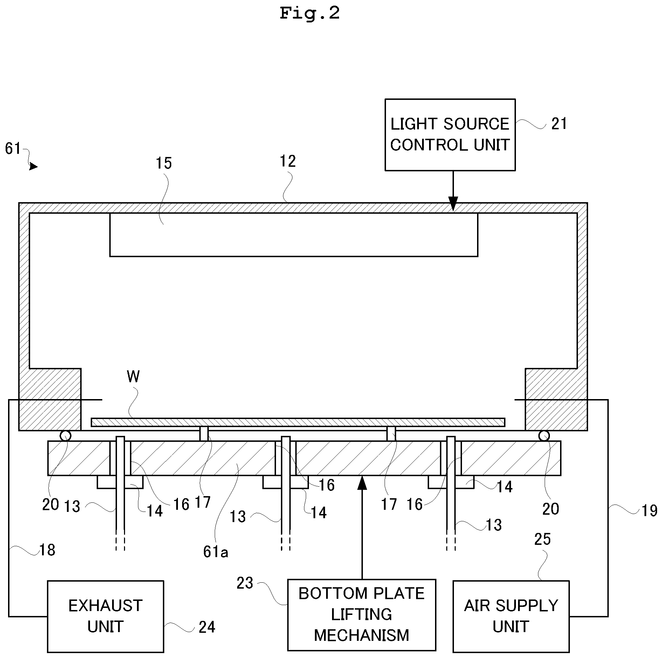

FIG. 2 illustrates a configuration of the light irradiation chamber 61 of the present embodiment. The light irradiation chamber 61 includes a base plate 61a that supports the substrate W, a cover member 12 having an opening 26 to be closed by the base plate 61a, and an annular seal member 20 interposed between the base plate 61a and the cover member 12. The seal member 20 is fixed to the base plate 61a.

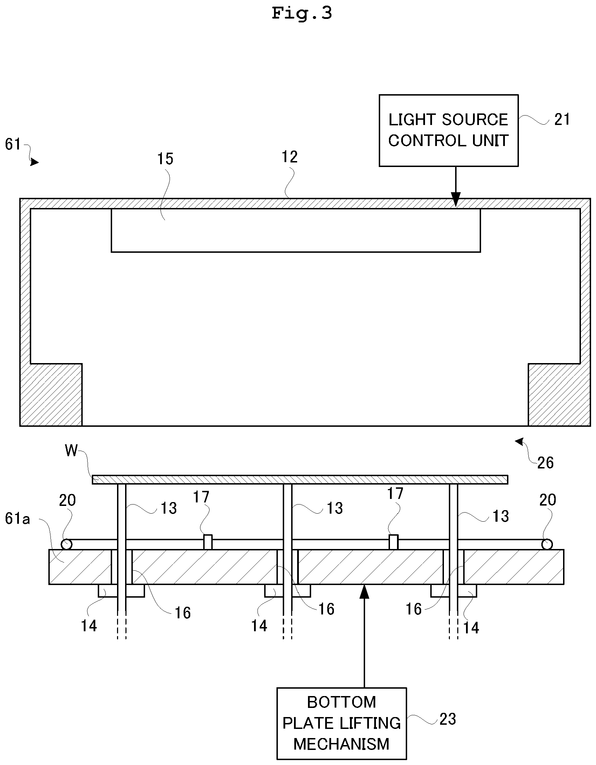

A bottom plate lifting mechanism 23 lifts and lowers the base plate 61a with respect to the cover member 12. The base plate 61a can take two states of the state of FIG. 2 in which the seal member 20 is brought into close contact with the opening 26 of the cover member 12 by the bottom plate lifting mechanism 23 and the state of FIG. 3 in which the seal member 20 is separated from the opening 26 of the cover member 12.

The cover member 12 and the base plate 61a are robust to such an extent that an internal space surrounded by the cover member 12, the base plate 61a, and the seal member 20 can be evacuated. This degassing of the internal space is realized by an exhaust unit 24 including a vacuum pump. An exhaust pipe 18 is a pipe that connects the exhaust unit 24 to the internal space of the cover member 12. The supply of air to the internal space in the vacuum state is realized by an air supply unit 25. An air supply pipe 19 is a pipe that connects the air supply unit 25 to the internal space of the cover member 12. FIG. 2 illustrates the light irradiation chamber 61 in which the internal space of the cover member 12 is in a vacuum state.

FIG. 3 illustrates the light irradiation chamber 61 in a state where the substrate W in a horizontal orientation can be moved in and out by separating the base plate 61a from the cover member 12. As illustrated in FIG. 3, the base plate 61a is provided with through holes 16 extending in the vertical directions. Each through hole 16 is provided with a lift pin 13 that can protrude and retract from the base plate 61a. The number of lift pins 13 is, for example, 3. The lift pins 13 protrude and retract from the base plate 61a in a state where the heights of the tips are matched. The substrate W conveyed to the light irradiation chamber 61 by the first center robot CR1 is held at the tips of the lift pins 13 in an extended state.

Fixing pins 17 capable of holding the substrate W are provided on the upper surface of the base plate 61a. The number of the fixing pins 17 is, for example, four, but is two in FIGS. 2 and 3 for convenience of drawing. The fixing pins 17 are configured to hold the substrate W when the lift pins 13 are in a contracted state as illustrated in FIG. 2. In this manner, in the light irradiation chamber 61 of the present embodiment, when the base plate 61a is lowered and the internal space of the cover member 12 is continuous with the outside air, the substrate W is supported by the lift pins 13 in the extended state. On the other hand, in the light irradiation chamber 61 of the present embodiment, when the base plate 61a is lifted and the internal space of the cover member 12 is isolated from the outside air, the substrate W is supported by the fixing pins 17 instead of the lift pins 13 in the contracted state.

A light source 15 capable of emitting ultraviolet light is attached to a ceiling part of the cover member 12 constituting an upper end of the internal space. The light source 15 may be, for example, ultraviolet light emitting diodes (UVLED) arrayed vertically and horizontally, a xenon lamp, or a mercury lamp. When the light source 15 is UVLEDs, the wavelength of ultraviolet light to be emitted from the light source 15 is 385 nm. When the light source 15 is a xenon lamp or a mercury lamp, the wavelength of ultraviolet light to be emitted from the light source 15 is 172 nm or 365 nm. The wavelength of the ultraviolet light to be emitted from the light source 15 is appropriately 172 nm to 385 nm, that is, 400 nm or less. The ultraviolet light irradiation amount at this time is preferably 200 mJ/cm² or more. This point will be described later.

A light source control unit 21 is configured to control irradiation with ultraviolet light by controlling whether to supply power to the light source 15. The light source control unit 21 causes the light source 15 to emit ultraviolet light in a case where the internal space of the cover member 12 is kept vacuum.

A sealing member 14 is provided at a position that closes the through hole 16 on the lower surface of the base plate 61a, which secures sealability of the internal space so that outside air does not enter from the internal space of the cover member 12 through the through hole 16 while allowing the lift pins 13 to freely move back and forth.

The operation of the light irradiation chamber 61 will be described. In the initial state of the light irradiation chamber 61, as illustrated in FIG. 3, the base plate 61a is located at a lower position, and the lift pins 13 are in the extended state. The first center robot CR1 can insert the hand 56 into the gap between the cover member 12 and the base plate 61a to load the unprocessed substrate W onto the tips of the lift pins 13 or to acquire the substrate W that has been processed and placed on the tips of the lift pins 13 and unload the substrate from the light irradiation chamber 61.

When ultraviolet light irradiation is performed on the substrate W, first, the seal member 20 is brought into close contact with the lower surface of the cover member 12 by lifting the base plate 61a. Then, as illustrated in FIG. 2, the lift pins 13 are brought into a contracted state to deliver the substrate W to the fixing pins 17.

Thereafter, the exhaust unit 24 operates to bring the internal space of the cover member 12 into a vacuum state. Thereafter, the light source control unit 21 irradiates the substrate W with ultraviolet light.

When the ultraviolet light irradiation processing is completed, the air supply unit 25 operates to make the internal space of the cover member 12 have the same pressure as that of the outside air. Thereafter, the base plate 61a moves downward, the lift pins 13 come into the extended state as illustrated in FIG. 3, and the substrate W supported by the fixing pins 17 is acquired by the lift pins 13. The first center robot CR1 can unload the substrate W acquired by the lift pins 13 from the light irradiation chamber 61.

### 5. Developer Block

The developer block 7 is configured to mainly develop the substrate W after the exposure processing. The developer block 7 includes a fifth line CL5 located at the back of the path 54, a fourth line CL4 provided on the left side of the fifth line CL5, and a sixth line CL6 provided on the right side of the fifth line CL5. Thus, the fifth line CL5 is located at a position sandwiched between the fourth line CL4 and the sixth line CL6 from the left and right.

In the fourth line CL4, development chambers 71 each including a spin chuck 8 that rotatably supports the substrate W and a nozzle 10 that discharges a chemical liquid are arrayed in the X directions. In the fourth line CL4 of FIG. 1, a state in which two development chambers 71 are arrayed in the front-back directions is described. In the fourth line CL4, the development chambers 71 are stacked. The number of layers included in the stacked body formed of the development chambers 71 can be appropriately changed.

The fifth line CL5 is a passage through which a second center robot CR2 that conveys the substrate W in a horizontal orientation moves back and forth. In addition to the above-described path 54, the second center robot CR2 can access the development chamber 71 included in the fourth line CL4, and a heat processing chamber 75, a cooling unit 78, and a path 74, which will be described later, provided in the sixth line CL6.

Similarly to the first center robot CR1, the second center robot CR2 is movable forward and backward in the X directions and movable up and down in the Z directions so as to be able to convey the substrate W to each accessible position. The second center robot CR2 can direct a hand 76 holding the substrate W to at least any of the front left and right.

In the sixth line CL6, the heat processing chamber 75 that heats the substrate W and the cooling unit 78 that cools the substrate W are arrayed in the X directions. The heat processing chamber 75 has the same configuration as that of the heat processing chamber 55 in the third line. Thus, the heat processing chamber 75 is configured by arraying a circular hot plate 75a and a circular post-heating processing plate 75b in the Y directions. The cooling unit 78 has the same configuration as the cooling unit 58 of the third line CL3. Thus, the cooling unit 78 is provided with a circular cooling processing plate 58a.

The path 74 is provided at a back end portion of the sixth line CL6. The substrate W in a horizontal orientation can move back and forth between the developer block 7 and the interface block 9 via the path 74.

### 6. Interface Block

The interface block 9 includes a path 94 that can cool the placed substrate W, a first robot R1 that can access the path 94 and the above-described path 74, and a second robot R2 that can access the path 94 and the stepper 2. The first robot R1 includes a hand 961 that can grip the substrate W in a horizontal orientation placed on the path 74, and the second robot R2 includes a hand 962 that can grip the substrate W in a horizontal orientation placed on the path 94.

The paths 94 are stacked in the Z directions to form a stacked body.

### 6. Stepper

The stepper 2 receives the substrate W before the exposure processing conveyed by the second robot R2, performs the exposure processing, and prints a circuit pattern of a device on the photoresist layer of the substrate W. The substrate W after the exposure processing is delivered to the second robot R2.

### 7. Controller

As illustrated in FIG. 1, the substrate processing apparatus 1 includes a controller 131 related to the control of the apparatus. Although not illustrated in FIG. 1, the controller 131 is provided with a corresponding storage unit. The controller 131 includes, for example, a central processing unit (CPU). A specific configuration of the controller is not limited, and for example, the controls related to the substrate processing apparatus 1 may be configured by a single processor, or each control may be configured by an individual processor.

Examples of the control related to the controller 131 include the controls related to the indexer robot IR, the first center robot CR1, the second center robot CR2, the first robot R1, and the second robot R2.

The storage unit stores programs, parameters, and the like related to the control. The controller may be configured by a single device or may be configured by individual devices corresponding to respective controls. The substrate processing apparatus 1 of the present embodiment is not particularly limited in the configuration of the device that implements the storage unit.

### 8. Film Formation Process

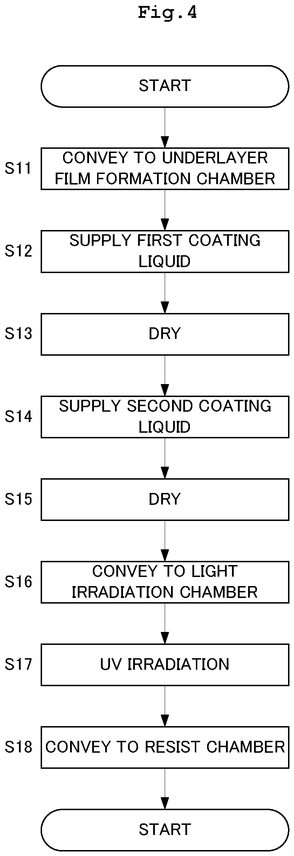

FIG. 4 is a flowchart for describing a process when the coater block 5 of the present embodiment forms an SOC layer, an SOG layer, and a photoresist layer on the substrate W. Hereinafter, a process of forming each layer will be described with reference to FIG. 4.

Step S11: The substrate W stored in the carrier C is conveyed to the underlayer film formation chamber 51 of the coater block 5 through the indexer block 3. The indexer robot IR conveys the substrate W stored in the carrier C to the path 34 leading to the coater block 5. The first center robot CR1 conveys the substrate W held by the path 34 to the underlayer film formation chamber 51. The underlayer film formation chamber 51 rotatably supports the substrate W via the spin chuck 8.

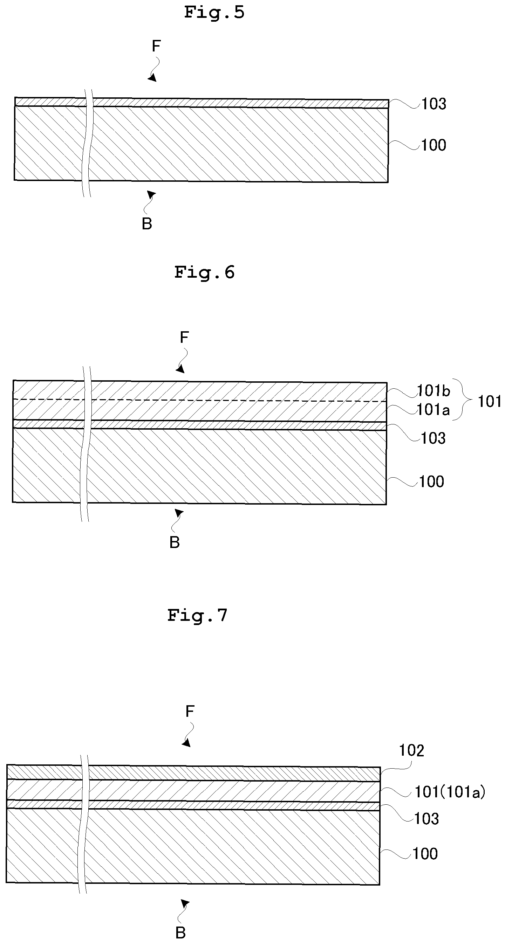

FIG. 5 is a sectional view for describing the configuration of the substrate W stored in the carrier C. The substrate W includes a base 100 having a thickness that is the thickness of the base when the base is cut out from a silicon ingot, and a processing target layer 103 provided on an upper surface of the base 100. In the substrate W, the surface having the processing target layer 103 is a front surface F, and the surface not having the processing target layer 103 is a back surface B. The front surface F is a device surface on which a device is formed in the substrate W.

The processing target layer 103 is made of, for example, a conductive material such as a metal film or an insulating material such as silicon oxide. The processing target layer 103 is a film to be processed in photolithography that is to be partially removed by etching.

Step S12: After the rotation of the substrate W with the spin chuck 8 is started, the nozzle 10 turns to position the tip of the nozzle 10 above the upper surface of the substrate W. In this state, the nozzle 10 discharges the first coating liquid toward the substrate W. The first coating liquid spreads from the center of the rotating substrate W toward the outside of the substrate W and covers the front surface F of the substrate W. When the first coating liquid has sufficiently spread over the substrate W, the nozzle 10 stops discharging the first coating liquid.

Step S13: The solvent of the first coating liquid covering the front surface of the substrate W is dried. The first coating liquid may be dried by spin drying in addition to natural drying. The first coating liquid is dried on the front surface of the substrate W to form a first layer. The first layer is composed of the polymer aromatic compound and the photo-crosslinking agent contained in the first coating liquid.

FIG. 6 illustrates the first layer 101 generated in the step S13. As illustrated in FIG. 6, the first layer 101 covers the upper surface of the processing target layer 103. The first layer 101 includes a lower layer 101a that becomes an SOC layer in a subsequent light irradiation step (step S16 in FIG. 4) and a higher layer 101b that dissolves with the second coating liquid and disappears in a subsequent step (step S14 in FIG. 4). That is, the higher layer 101b is dissolved by the second coating liquid and scattered by the rotation of the substrate W, and thus the film thickness of the first layer 101 decreases. In this sense, the higher layer 101b can be said to be a film that disappears through subsequent substrate processing. The film thickness of the first layer 101 is, for example, about 200 nm. The film thickness of the first layer 101 can be appropriately changed by adjusting the rotation speed of the spin chuck 8 in the step S12.

The above-described step S12 and step S13 correspond to a first film-formation step of the present invention. The steps S12 and S13 are steps of applying the first coating liquid containing an organic material and the first photo-crosslinking agent onto a substrate to generate the first layer 101. The underlayer film formation chamber 51 supplies the first coating liquid containing at least the organic material and the first photo-crosslinking agent as described above onto the substrate to generate the first layer 101.

Step S14: The nozzle 10 discharges the second coating liquid toward the substrate W. The second coating liquid spreads from the center of the rotating substrate W toward the outside of the substrate W and covers the front surface F of the substrate W. When the second coating liquid has sufficiently spread over the substrate W, the nozzle 10 stops discharging the second coating liquid.

Step S15: The solvent of the second coating liquid covering the front surface of the substrate W is dried. The second coating liquid may be dried by spin drying in addition to natural drying as in the present embodiment. The second coating liquid is dried on the front surface of the substrate W to form a second layer. The second layer is composed of the polysilicon compound and the second photo-crosslinking agent contained in the second coating liquid. The underlayer film formation chamber 51 supplies the second coating liquid containing at least a silicon material and the second photo-crosslinking agent onto the substrate to generate the second layer 102.

The above-described step S14 and step S15 correspond to a second film-formation step of the present invention. In the step S14 and the step S15, the second coating liquid containing the silicon material and the second photo-crosslinking agent is applied onto the first layer 101 to generate the second layer 102. The underlayer film formation chamber 51 supplies the second coating liquid containing at least the silicon material and the second photo-crosslinking agent as described above on the substrate to generate the second layer 102.

FIG. 7 illustrates the second layer 102 generated in the step S15. As illustrated in FIG. 7, the second layer 102 covers the upper surface of the lower layer 101a of the first layer 101. In the step S14, when the second coating liquid is supplied from the nozzle 10 to the substrate W, the higher layer 101b of the first layer 101 on the front surface F of the substrate W is dissolved by the solvent contained in the second coating liquid. This portion scatters and disappears through the rotation operation of the substrate W.

When drying of the solvent of the second coating liquid is started in the step S15, elution of the first layer 101 because of the second coating liquid stops. This is because the supply of the new second coating liquid stops, and the solvent that causes erosion of the first layer 101 is lost from the surface of the substrate W because of drying. The film thickness of the second layer 102 is, for example, about 10 nm to 35 nm. The film thickness of the second layer 102 can be appropriately changed by adjusting the rotation speed of the spin chuck 8 in the step S14. On the other hand, the film thickness of the first layer 101 (lower layer 101a) remaining on the surface of the substrate W is, for example, about 60 nm to 100 nm. The film thickness of the lower layer 101a in the first layer 101 can be appropriately changed by adjusting the supply amount of the second coating liquid in the step S14.

Step S16: The substrate W having the second layer 102 formed on the front surface F is conveyed to the light irradiation chamber 61 by the first center robot CR1.

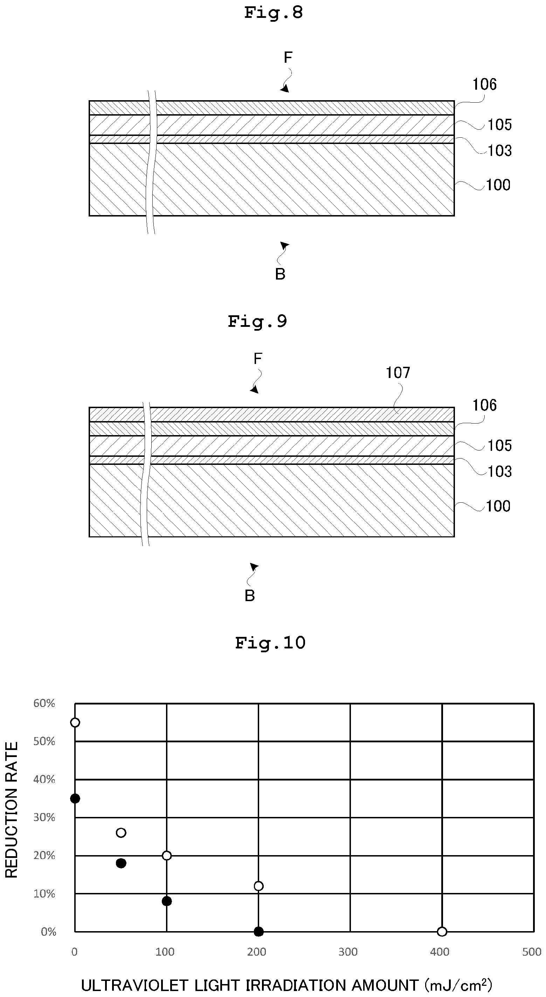

Step S17: The substrate W is irradiated with ultraviolet light. Then, as illustrated in FIG. 8, the first layer 101 (lower layer 101a) cures through a polymerization reaction to become the SOC layer 105 (organic layer). In the same manner, the second layer 102 cures through a polymerization reaction to become the SOG layer 106 (silicon layer). In this manner, in the present embodiment, the SOC layer 105 and the SOG layer 106 are simultaneously formed by one time of irradiation with ultraviolet light. The step S17 corresponds to a light irradiation step of the present invention. The step S17 is a step of irradiating the stacked body formed of the first layer 101 and the second layer 102 with ultraviolet light, curing the first layer 101 through a crosslinking reaction to form the SOC layer 105, and curing the second layer 102 through a crosslinking reaction to form the SOG layer 106.

In this manner, in the step S17, the SOG layer 106 causes the ultraviolet light emitted by the light source 15 (see FIG. 2) to reach the first layer 101. As a result, the first layer 101 reliably cures and become the SOC layer 105. The light irradiation chamber 61 irradiates the stacked body formed of the first layer 101 and the second layer 102 with ultraviolet light to cure the first layer 101 through a crosslinking reaction and form the SOC layer 105, and cures the second layer 102 through a crosslinking reaction to form the SOG layer 106.

Step S18: Thereafter, the substrate W is conveyed to the resist chamber 53, and a photoresist layer is formed. FIG. 9 illustrates the photoresist layer 107 formed in this manner. As illustrated in FIG. 9, on the front surface F of the substrate W before exposure processing, the processing target layer 103, the SOC layer 105, the SOG layer, and the photoresist layer 107 are stacked in this order on the upper surface of the base 100. The film thickness of the photoresist layer 107 is, for example, 35 nm to 60 nm. The step S18 corresponds to a photoresist layer generation step of the present invention. The step S18 generates a photoresist layer on the cured stacked body. The resist chamber 53 corresponds to a third chamber of the present invention. The resist chamber 53 generates the photoresist layer 107 on the SOG layer 106. The film formation process on the substrate W in the present embodiment thus ends.

### 9. Appropriate Ultraviolet Light Irradiation Amount

An appropriate irradiation amount of ultraviolet light in the step S17 is preferably 200 mJ/cm². FIG. 10 shows experimental results showing an appropriate ultraviolet irradiation amount. The black circles in FIG. 10 indicate how much the first layer 101 is reduced when the first layer 101 is spin-coated with a PGME/PGMEA mixed solution (ratio of PGME : PGMEA = 7 : 3) without being subjected to firing processing after being subjected to ultraviolet light processing with each irradiation amount under different conditions, in a state where the first layer 101 is generated on the substrate and the second layer 102 is not formed. In the graph, 0 also indicates a reduction rate when no ultraviolet light processing is performed for comparison. According to the graph, it can be seen that the first layer 101 is sufficiently cured when the irradiation amount of ultraviolet rays is 200 mJ/cm² or more.

The white circles in FIG. 10 indicate how much the first layer 101 is reduced when the first layer 101 is spin-coated with a PGME/PGNMA mixed solution (ratio of PGME : PGMEA = 7 : 3) without being subjected to firing processing after being subjected to ultraviolet light processing with each irradiation amount under different conditions, in a state where the second layer 102 is generated on the substrate. In the graph, 0 also indicates a reduction rate when no ultraviolet light processing is performed for comparison. According to the graph, it can be seen that the second layer 102 is sufficiently cured when the irradiation amount of ultraviolet rays is 200 mJ/cm² or more. The configuration of the present embodiment is characterized in that the first layer 101 and the second layer 102 are cured by one-time irradiation with ultraviolet light, and the irradiation amount of ultraviolet light at this time is preferably 200 mJ/cm² or more. This is because the experiment has shown that the irradiation amount is sufficient for curing the first layer 101 and the second layer 102.

### 10. Flow of Substrate Processing

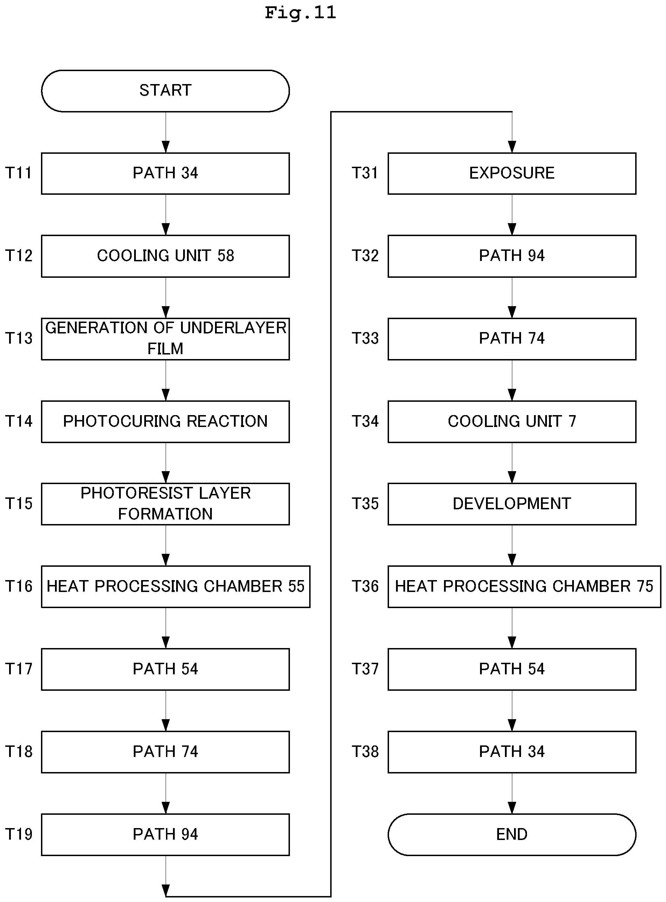

Next, a flow of substrate processing in the present embodiment will be described with reference to the flowchart of FIG. 11.

Step T11: The unprocessed substrate W stored in the carrier C is conveyed to the path 34 by the indexer robot IR.

Step T12: The first center robot CR1 in the coater block 5 conveys the substrate W acquired from the path 34 to the cooling unit 58. The substrate W is subjected to cooling processing by the cooling unit 58.

Step T13: The first center robot CR1 conveys the substrate W in the cooling unit 58 to the underlayer film formation chamber 51. The substrate W is subjected to film formation processing for the first layer 101 (lower layer 101a) and the second layer 102 by the underlayer film formation chamber 51.

Step T14: The first center robot CR1 conveys the substrate W in the underlayer film formation chamber 51 to the light irradiation chamber 61. The substrate W is subjected to ultraviolet light irradiation processing by the light irradiation chamber 61.

Step T15: The first center robot CR1 conveys the substrate W in the heat processing chamber 55 to the resist chamber 53. The substrate W is subjected to film formation processing for a photoresist layer by the resist chamber 53.

Step T16: The first center robot CR1 conveys the substrate W in the resist chamber 53 to the heat processing chamber 55. The substrate W is subjected to heat processing by the heat processing chamber 55.

Step T17: The first center robot CR1 conveys the substrate W in the heat processing chamber 55 to the path 54. The substrate W on which the photoresist layer is formed thus exits the coater block 5.

Step T18: The second center robot CR2 in the developer block 7 conveys the substrate W on the path 54 to the path 74.

Step T19: The first robot R1 in the interface block 9 conveys the substrate W on the path 74 to the path 94.

Step T31: The second robot R2 conveys the substrate W on the path 94 to the stepper 2. The stepper 2 performs exposure processing on the substrate W through a mask corresponding to a circuit pattern of a necessary device.

Step T32: The second robot R2 acquires the substrate W subjected to the exposure processing from the stepper 2 and conveys the substrate W to the path 94.

Step T33: The first robot R1 conveys the substrate W on the path 94 to the path 74. The substrate W after the exposure processing thus exits the interface block 9.

Step T34: The second center robot CR2 in the developer block 7 conveys the substrate W on the path 74 to the cooling unit 78. The substrate W is subjected to a cooling processing by the cooling unit 78.

Step T35: The second center robot CR2 conveys the substrate W in the cooling unit 78 to the development chamber 71. The substrate W is subjected to development processing by the development chamber 71.

Step T36: The second center robot CR2 conveys the substrate W in the development chamber 71 to the heat processing chamber 75. The substrate W is subjected to heat processing by the heat processing chamber 75.

Step T37: The second center robot CR2 conveys the substrate W in the heat processing chamber 75 to the path 54. The substrate W subjected to the development processing thus exits the developer block 7.

Step T38: The first center robot CR1 in the coater block 5 conveys the substrate W on the path 54 to the path 34. The substrate W subjected to the development processing thus exits the coater block 5. The substrate W on the path 34 is returned to the original carrier C by the indexer robot IR.

### 11. Effects of Invention

The configuration described above includes the step S12 and the step S13 of applying a first coating liquid containing an organic material and a first photo-crosslinking agent onto a substrate to form the first layer 101, the step S14 and the step S15 of applying a second coating liquid containing a silicon material and a second photo-crosslinking agent onto the first layer 101 to generate the second layer 102, and a light irradiation step of irradiating a stacked body formed of the first layer 101 and the second layer 102 with light, curing the first layer 101 through a crosslinking reaction to form the SOC layer 105, and curing the second layer 102 through a crosslinking reaction to form the SOG layer 106. That is, in the substrate processing method of the present embodiment, the second layer 102 is formed on the first layer 101 before the first layer 101 is cured through a crosslinking reaction, and the first layer 101 and the second layer 102 are cured at once by light irradiation, whereby each of the SOC layer 105 and the SOG layer 106 is formed. According to the present embodiment, since the first layer 101 and the second layer 102 are cured together, the formation of the plurality of layers is simplified as compared with the method of forming the second layer 102 after the SOC layer 105 is generated. The present embodiment can provide an optimal substrate processing method from the viewpoint of power saving and downsizing of the apparatus.

According to the above configuration, the first layer 101 in the first layer generation step includes the lower layer 101a that becomes the SOC layer 105 in the light irradiation step and the higher layer 101b that dissolves with the second coating liquid and disappears. This configuration can realize the configuration of the present embodiment only by forming the first layer 101 to be thick.

According to the above configuration, the light for irradiation in the light irradiation step has a wavelength of any of 172 nm to 385 nm. When the light for irradiation in the light irradiation step is ultraviolet light, the first layer 101 and the second layer 102 can reliably become the SOC layer 105 and the SOG layer 106.

According to the above configuration, the SOG layer 106 causes the light for irradiation to reach the first layer 101 in the light irradiation step. This configuration can prevent a situation in which light for irradiation in the light irradiation step is absorbed by the SOG layer 106 and does not reach the first layer 101, and the first layer 101 can reliably become the SOC layer 105.

The substrate processing apparatus includes the underlayer film formation chamber 51 that supplies a first coating liquid containing at least an organic material and a first photo-crosslinking agent onto a substrate to generate the first layer 101, underlayer film formation chamber 51 that supplies a second coating liquid containing at least a silicon material and a second photo-crosslinking agent onto the first layer 101 to generate the second layer 102, a light irradiation chamber that irradiates a stacked body formed of the first layer 101 and the second layer 102 with ultraviolet light to cure the first layer 101 through a crosslinking reaction and generate the SOC layer 105 and to cure the second layer 102 through a crosslinking reaction and generate the SOG layer 106, and the resist chamber 53 that generates a photoresist layer on the SOG layer 106. According to the present embodiment, since the first layer 101 and the second layer 102 are cured together, the formation of the plurality of layers is simplified as compared with the method of forming the second layer 102 after the SOC layer 105 is generated. The present embodiment can provide an optimal substrate processing apparatus from the viewpoint of power saving and downsizing of the apparatus.

### 12. Modifications of Invention

The present invention is not limited to the above-described configuration but can be modified as follows.

### <First Modification>

According to the above configuration, the solvent of the second coating liquid is PGMEA or PGME, but the present invention is not limited to this configuration. The solvent of the second coating liquid can be a poorly soluble solvent as compared to PGMEA or the like. As the solvent of the second coating liquid, for example, methyl isobutyl carbinol (MIBC) or water can be selected. According to the present modification, the solvent of the second coating liquid is less likely to dissolve the organic material serving as the solute of the first coating liquid than the solvent of the first coating liquid. With this configuration, it becomes difficult for the second coating liquid to dissolve the first layer 101 when the second coating liquid is applied to the first layer 101. Thus, a stacked structure of the first layer 101 and the second layer 102 can be generated without estimating the thickness of the layer to dissolve in the second coating liquid and forming the first layer 101 thick.

According to the present modification, elution of the higher layer 101b in the first layer 101 can also be suppressed. This is because the poorly soluble solvent has a lower ability to elute the first layer 101 than PGMEA or the like. Such circumstances are advantageous because elution of the first layer 101 because of the second coating liquid can be suppressed. However, in the method of the present modification, a mixing layer in which the first layer 101 and the second layer 102 are mixed may be generated between the first layer 101 and the second layer 102. The mixing layer may interfere with exposure and etching. Thus, it is preferable to dry the first layer 101 in advance through the firing step so as not to generate the mixing layer.

### <Second Modification>

An additive that promotes dissolution of the silicon material into the solvent may be added to form the second coating liquid. As the additive, for example, poly vinylidene fluoride (PVDF) is preferable. This configuration makes it easy to generate a stacked structure of the first layer 101 and the second layer 102.

### <Third Modification>

According to the above configuration, the solvent contained in the first layer 101 is removed by natural drying or spin drying, but the present invention is not limited to this configuration. That is, a first firing step of removing the solvent contained in the first layer 101 may be provided after the step S12 and before the step S14. According to such a configuration, since the first layer 101 can be reliably dried, the SOC layer 105 can be easily generated. The first firing step is realized in the heat processing chamber 55 illustrated in FIG. 1. The conveyance of the substrate W from the underlayer film formation chamber 51 to the heat processing chamber 55 is realized by the first center robot CR1. The substrate W after the firing processing is conveyed from the heat processing chamber 55 to the underlayer film formation chamber 51 by the first center robot CR1.

According to the present modification, in the first firing step, the substrate is fired at any temperature from 100°C to 150°C. When the first firing step is low-temperature firing, a substrate processing method in which power is saved can be provided. In the first firing step, particularly when the solvent of the first coating liquid is PGME or PGMEA, the substrate W is preferably fired at a temperature of 200°C or higher.

The drying related to the first layer 101 may be performed by other drying methods such as vacuum drying.

### <Fourth Modification>

According to the above configuration, the solvent contained in the second layer 102 is removed by natural drying or spin drying, but the present invention is not limited to this configuration. That is, a second firing step of removing the solvent contained in the second layer 102 may be provided after the step S14 and before the step S16. According to such a configuration, since the second layer 102 can be reliably dried, the SOG layer 106 can be easily generated. The second firing step is also realized in the heat processing chamber 55 illustrated in FIG. 1. The conveyance of the substrate W between the underlayer film formation chamber 51 and the heat processing chamber 55 is realized by the first center robot CR1.

According to the present modification, in the second firing step, the substrate is fired at any temperature from 100°C to 150°C. When the second firing step is low-temperature firing, a substrate processing method in which power is saved can be provided. In the second firing step, particularly when the solvent of the second coating liquid is PGME or PGMEA, the substrate W is preferably fired at a temperature of 200°C or higher.

The drying related to the second layer 102 may be performed by other drying methods such as vacuum drying.

### <Fifth Modification>

The present invention can also be applied to forming a stacked structure other than the structure described in FIG. 9, such as providing an antireflection film between the SOG layer 106 and the photoresist layer 107.

### <Sixth Modification>

In the above-described configuration, the formation of the first layer 101 and the formation of the second layer 102 are performed in the same underlayer film formation chamber 51, but the present invention is not limited to this configuration. The first layer 101 and the second layer 102 may be formed in different chambers.

### <Seventh Modification>

In the underlayer film formation chamber 51 described above, the first layer 101 is formed by spin coating, but the present invention is not limited to this configuration. The first layer 101 may be formed by capillary coating or slit coating. The same applies to the second layer 102.

## Claims

1. A substrate processing method for generating a stacked structure including an organic layer, a silicon layer (106), and a photoresist layer (107) on a substrate, the substrate processing method comprising:
a first layer (101) generation step of applying a first coating liquid containing an organic material and a first photo-crosslinking agent onto a substrate to form a first layer (101);
a second layer (102) generation step of applying a second coating liquid containing a silicon material and a second photo-crosslinking agent onto the first layer (101) to generate a second layer (102);
a light irradiation step of irradiating a stacked body formed of the first layer (101) and the second layer (102) with light, curing the first layer (101) through a crosslinking reaction to form the organic layer, and curing the second layer (102) through a crosslinking reaction to form the silicon layer (106); and
a photoresist layer (107) generation step of generating a photoresist layer (107) on the stacked body that has been cured.

2. The substrate processing method according to claim 1, wherein
the first layer (101) in the first layer (101) generation step includes a lower layer that becomes the organic layer in the light irradiation step and a higher layer that dissolves with the second coating liquid and disappears.

3. The substrate processing method according to claim 1, wherein
a solvent of the second coating liquid in the second layer (102) generation step is less likely to dissolve the organic material than a solvent of the first coating liquid in the first layer (101) generation step.

4. The substrate processing method according to claim 3, wherein
the second coating liquid in the second layer (102) generation step contains an additive that promotes dissolution of the silicon material into the solvent.

5. The substrate processing method according to claim 1, wherein
light for irradiation in the light irradiation step is ultraviolet light having a wavelength of any of 172 nm to 385 nm.

6. The substrate processing method according to claim 1, wherein
the silicon layer (106) causes the light for irradiation to reach the first layer (101) in the light irradiation step.

7. The substrate processing method according to claim 1, the substrate processing method comprising:
a first firing step of removing a solvent contained in the first layer (101) after the first layer (101) generation step and before the second layer (102) generation step; and
a second firing step of removing a solvent contained in the second layer (102) after the second layer (102) generation step and before the light irradiation step.

8. The substrate processing method according to claim 7, wherein
in the first firing step, the substrate is fired at any temperature from 100°C to 150°C, and
in the second firing step, the substrate is fired at any temperature from 100°C to 150°C.

9. A substrate processing apparatus that generates a stacked structure including an organic layer, a silicon layer (106), and a photoresist layer (107) on a substrate, the substrate processing apparatus comprising:
a first chamber that supplies a first liquid containing at least an organic material and a first photo-crosslinking agent onto a substrate to generate a first layer (101);
a second chamber that supplies a second liquid containing at least a silicon material and a second photo-crosslinking agent onto the first layer (101) to generate a second layer (102);
a light irradiation chamber that irradiates a stacked body formed of the first layer (101) and the second layer (102) with light to cure the first layer (101) through a crosslinking reaction and generate an organic layer and to cure the second layer (102) through a crosslinking reaction and generate a silicon layer (106); and
a third chamber that generates a photoresist layer (107) on the silicon layer (106).
